# EUROPEAN PATENT SPECIFICATION

(11) **EP 3 646 464 B1**
(45) Date of publication and mention of the grant of the patent: **15.02.2023**
(21) Application number: 18731762.3
(22) Date of filing: 07.06.2018
(51) Int. Cl.: H03K 17/0812, H03K 17/16

(54) **HIGH-SIDE GATE DRIVER**
HOCHSEITIGER GATE-TREIBER
CIRCUIT D'ATTAQUE DE GRILLE CÔTÉ HAUT

(30) Priority: 28.06.2017 CN 201720768261 U
(43) Date of publication of application: 06.05.2020
(73) Proprietor: Robert Bosch GmbH, 70442 Stuttgart (DE)
(72) Inventor: ZHENG, Zhong, Shanghai 200335 (CN); DING, Qibing, Shanghai 200335 (CN); JIANG, Ming, Shanghai 200335 (CN)
(86) International application number: PCT/EP2018/065062
(87) International publication number: WO 2019/001925

(56) References cited:
- EP-A1- 0 926 826
- US-A1- 2007 290 738
- WENDT M ET AL: "A Configurable High-Side/Low-Side Driver With Fast and Equalized Switching Delay", IEEE JOURNAL OF SOLID-STATE CIRCUITS, IEEE SERVICE CENTER, PISCATAWAY, NJ, USA, vol. 40, no. 7, 1 July 2008 (2008-07-01), pages 1617-1625, XP011229247, ISSN: 0018-9200

## Description

### Technical field

The present invention relates in general to the field of high-side gate drivers, and more specifically relates to a high-side gate driver capable of meeting a negative voltage requirement of a gate pin of a transistor.

### Background art

With regard to high-side gate drivers used in different application fields, in particular the field of motor vehicles, a negative voltage will occur at the source and gate of a power MOSFET (metal oxide semiconductor field effect transistor) for example, due to parasitic resistance and parasitic inductance of a PCB trace or PCB component and a large, fast current during transistor state conversion. Moreover, when an electronic control unit (ECU, electrical control unit) having a high-side gate driver is disconnected, such a negative voltage will also occur, due to capacitive coupling from another ECU in operation. When such a negative voltage is present at the source or gate of a power MOSFET, a large uncontrolled current will arise due to the internal latch-up effect of a transistor integrated in a chip, causing damage to the chip.

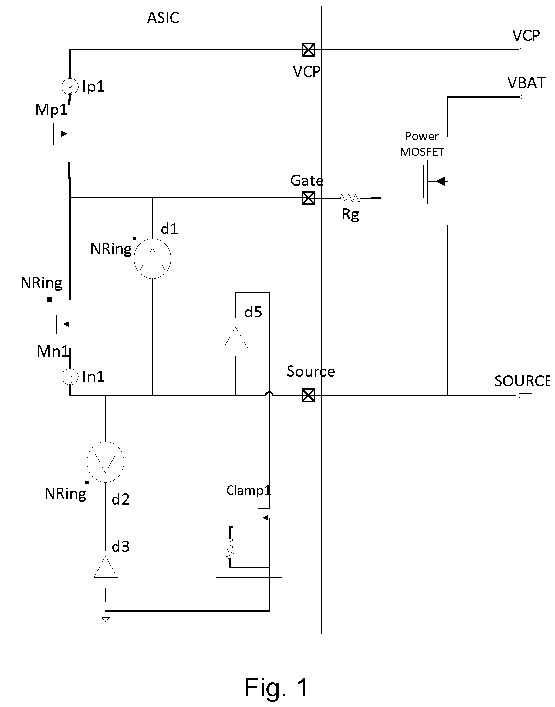

To solve the abovementioned problem, in an existing high-side gate driver, a current-limiting resistance Rg is generally disposed between a gate pin of the high-side gate driver and a gate pin of an external MOSFET, and may be used to respond to the problem of negative voltage between the source and gate, as shown in fig. 1, wherein the size of the current-limiting resistance Rg is determined by the particular application. However, owing to the need to additionally provide the current-limiting resistance Rg between the gate pin of the high-side gate driver and the gate pin of the external MOSFET, the development cost of the ECU unit is increased.

US 2007/290738 A1 describes an integrated circuit for switching loads, wherein a driver circuit for driving a MOS is used.

### Summary

In view of the abovementioned problem, the present invention provides a high-side gate driver, capable of meeting a negative voltage requirement of a gate pin of a power transistor when electrified and not electrified, with no need to additionally provide a current-limiting resistance between a gate pin of the high-side gate driver and a gate end of the power transistor to be driven.

The invention is defined as set out in independent claim 1. Further embodiments are depicted in the dependent claims.

According to one aspect, a high-side gate driver is provided, the driver comprising: first and second current mirrors (Ip1, In1), a first N-channel transistor (Mn1), first and second switch circuits, first and second first-type diodes (d1, d2), and a first second-type diode (d3), wherein the first switch circuit is arranged between an output end of the first current mirror (Ip1) and a source of the first N-channel transistor (Mn1), the second switch circuit is arranged between a drain of the first N-channel transistor (Mn1) and an input end of the second current mirror (In1), an anode and a cathode of the first first-type diode (d1) are arranged to be connected to the source of the first N-channel transistor (Mn1) and a cathode of the second first-type diode (d2) respectively, an anode of the second first-type diode (d2) is arranged to be connected to an output end of the second current mirror (In1), an anode and a cathode of the first second-type diode (d3) are arranged to be connected to ground and the cathode of the second first-type diode (d2) respectively; an input end of the first current mirror (Ip1), the source of the first N-channel transistor (Mn1) and the output end of the second current mirror (In1) are connected to a voltage pin, a gate pin and a source pin of the high-side gate driver respectively; and the first N-channel transistor (Mn1), the second switch circuit and the second current mirror (In1) have a structure electrically isolated from a substrate.

Using the high-side gate driver of the present invention, by arranging the gate pin of the high-side gate driver to be connected to the source of an N-channel transistor having a structure electrically isolated from a substrate and to the anode of a diode, the high-side gate driver is enabled to meet a negative voltage requirement of the gate pin of the power transistor when electrified and not electrified, with no need to additionally provide a current-limiting resistance between a gate output end of the high-side gate driver and a gate end of the transistor to be driven.

### Description of the accompanying drawings

Reference to the accompanying drawings below will enable further understanding of the substance and advantages of the content disclosed herein. In the drawings, similar components or features may have identical reference labels.
Fig. 1 shows a block diagram of an implementation example of a high-side gate driver in the prior art;
fig. 2 shows a circuit diagram of an implementation example of a high-side gate driver not covered by the invention; and
fig. 3 shows a circuit diagram of an implementation example of a high-side gate driver according to the present invention.

### Particular embodiments

A high-side gate driver is now described with reference to the accompanying drawings.

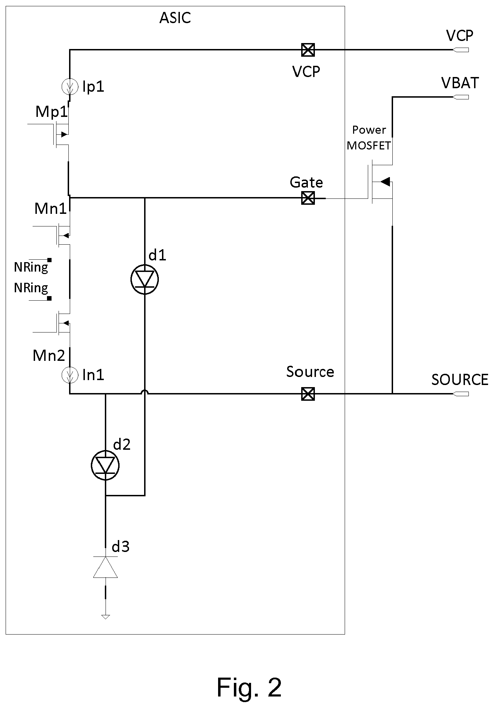

Fig. 2 shows a circuit diagram of an implementation example of a high-side gate driver. In fig. 2, the circuit part marked by the solid line box corresponds to a circuit diagram of the high-side gate driver . As shown in fig. 2, the high-side gate driver may be contained in an ASIC (application specific integrated circuit), i.e. the high-side gate driver may be realized in an ASIC.

As shown in fig. 2, the high-side gate driver comprises: first and second current mirrors Ip1 and In1, first and second N-channel transistors Mn1 and Mn2, a first P-channel transistor Mp1, and first to third diodes d1, d2 and d3. The first and second diodes d1 and d2 are bidirectionally conducting diodes (i.e. a first type of diode), and the third diode d3 is a unidirectionally conducting diode (i.e. a second type of diode).

An input end of the first current mirror Ip1 is arranged to be connected to a voltage pin VCP of the high-side gate driver. An output end of the first current mirror Ip1 is arranged to be connected to a source of the first P-channel transistor Mp1. The first current mirror Ip1 and the first P-channel transistor Mp1 are used to switch on the power MOSFET. Specifically, the first current mirror Ip1 is used for receiving a current supplied by an external charge pump, and charging the gate of the power MOSFET when the first P-channel transistor Mp1 is conducting. The first current mirror Ip1 may be realized using various circuit structures known in the art. Here, the action of the first P-channel transistor Mp1 is equivalent to a switch (i.e. a first switch circuit). When the first P-channel transistor Mp1 is conducting, a current from the first current mirror Ip1 flows towards the gate of the power MOSFET. When the first P-channel transistor Mp1 is cut off, a current from the first current mirror Ip1 is cut off, and does not flow towards the gate of the power MOSFET. In other examples of the present utility model, the first P-channel transistor Mp1 may be replaced by another type of switch circuit.

A source of the first N-channel transistor Mn1 is arranged to be connected to a drain of the first P-channel transistor Mp1 and an anode of the first diode d1. Moreover, the source of the first N-channel transistor Mn1 is also arranged to be connected to a gate pin (Gate) of the high-side gate driver, for supplying a gate discharge current, via the gate pin, to the power transistor to be driven, which is connected to the high-side gate driver, in order to drive the power transistor. The power transistor to be driven may for example be a power MOSFET (metal oxide semiconductor field effect transistor) or an IGBT (insulated gate bipolar transistor), etc. The first N-channel transistor Mn1 is arranged to have a structure electrically isolated from a substrate. For example, the structure electrically isolated from the substrate may be an N-ring structure, as shown in fig. 2.

A drain of the second N-channel transistor Mn2 is arranged to be connected to a drain of the first N-channel transistor Mn1, and a source of the second N-channel transistor Mn2 is arranged to be connected to an input end of the second current mirror In1. An output end of the second current mirror In1 is arranged to be connected to a source pin (Source) of the high-side gate driver. Here, the second current mirror In1 is used for receiving a current supplied by the gate of the power MOSFET, and discharging the gate of the power MOSFET when the second N-channel transistor Mn2 is conducting. The second current mirror In1 is arranged to have a structure electrically isolated from a substrate. For example, the structure electrically isolated from the substrate may be an N-ring structure, as shown in fig. 2. The second current mirror In1 may be realized using various circuit structures known in the art.

Likewise, the action of the second N-channel transistor Mn2 is equivalent to a switch. When the second N-channel transistor Mn2 is conducting, a current flows from the gate of the power MOSFET towards the source of the power MOSFET. When the second N-channel transistor Mn2 is cut off, a current from the second current mirror In1 is cut off. In other examples of the present utility model, the second N-channel transistor Mn2 may be replaced by another type of switch circuit having a structure electrically isolated from a substrate. Moreover, the second N-channel transistor Mn2 is arranged to have a structure electrically isolated from a substrate. For example, the structure electrically isolated from the substrate may be an N-ring structure, as shown in fig. 2.

In addition, it must be explained that the first and second current mirrors Ip1 and In1 do not operate simultaneously. That is, when the first current mirror Ip1 is operating, the second current mirror In1 is not operating. When the second current mirror In1 is operating, the first current mirror Ip1 is not operating.

In addition, as shown in fig. 2, the second and third diodes d2 and d3 are arranged between the output end of the second current mirror In1 and ground. Specifically, an anode of the second diode d2 is arranged to be connected to the output end of the second current mirror In1, a cathode of the second diode d2 is arranged to be connected to a cathode of the third diode d3, and an anode of the third diode d3 is arranged to be connected to ground.

In addition, as shown in fig. 2, the cathode of the second diode d2 is also arranged to be connected to a cathode of the first diode d1. That is, the first diode d1 is arranged between the source of the first N-channel transistor Mn1 (i.e. the Gate) and the cathode of the second diode d2. Specifically, the anode of the first diode d1 is arranged to be connected to the source of the first N-channel transistor Mn1, and the cathode of the first diode d1 is arranged to be connected to the cathode of the second diode d2.

In one example of the present utility model, the first and second diodes d1 and d2 may be snapback ESD diodes, and the third diode d3 may be an ESD diode. For example, the first and second diodes d1 and d2 may be snapback ESD diodes with a forward voltage of 0.7 V and a reverse voltage of 7 V, and the third diode d3 may be an ESD unidirectional diode with a forward voltage of 0.7 V. In other examples of the present utility model, the first and second diodes d1 and d2 could also be bidirectionally conducting diodes of another suitable type, and the third diode d3 could be a unidirectionally conducting diode of another suitable type.

A high-side gate driver according to an example has been described above with reference to fig. 2. Using the high-side gate driver in fig. 2, by arranging the gate pin (Gate) of the high-side gate driver to be connected to the source of an N-channel transistor having a structure electrically isolated from a substrate and to the anode of a diode having a structure electrically isolated from a substrate, the high-side gate driver is enabled to meet a negative voltage requirement of the gate pin of the power transistor when not electrified and electrified, with no need to additionally provide a current-limiting resistance between a gate output end of the high-side gate driver and a gate end of the transistor to be driven.

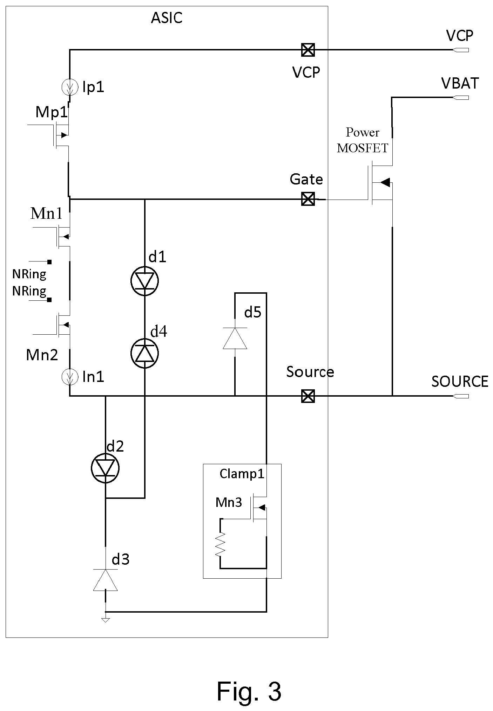

Fig. 3 shows a circuit diagram of an implementation example of a high-side gate driver according to the present invention. Compared with fig. 2, the high-side gate driver shown in fig. 3 also comprises a fourth diode d4 arranged between the cathode of the first diode d1 and the cathode of the second diode d2. Specifically, a cathode of the fourth diode d4 is arranged to be connected to the cathode of the first diode d1, and an anode of the fourth diode d4 is arranged to be connected to the cathode of the second diode d2. Here, the fourth diode d4 is a bidirectionally conducting diode. In one example of the present utility model, the fourth diode d4 may be a snapback ESD diode. For example, the fourth diode d4 may be a snapback ESD diode with a forward voltage of 0.7 V and a reverse voltage of 7 V.

In addition, a voltage-limiting circuit is provided in the high-side gate driver shown in fig. 3. The voltage-limiting circuit is arranged between the output end of the second current mirror (In1) and ground. As shown in fig. 3, the voltage-limiting circuit is formed of a fifth diode d5 and a clamping circuit clamp1; the clamping circuit clamp1 is formed of a third N-channel transistor Mn3 and a resistor. Here, the fifth diode d5 may be any type of unidirectionally conducting diode. The third N-channel transistor Mn3 may be any type N-channel transistor. Specifically, an anode of the fifth diode d5 is arranged to be connected to the output end of the second current mirror In1, a cathode of the fifth diode d5 is arranged to be connected to a drain of the third N-channel transistor Mn3, a source of the third N-channel transistor Mn3 is connected to ground, and the resistor is arranged between the source and a gate of the third N-channel transistor Mn3. In this case, the first to fourth diodes and the voltage-limiting circuit together can better realize ESD protection.

In other examples of the present disclosure, the voltage-limiting circuit and/or clamping circuit may be realized using another method known in the art.

In addition, parameters of the various circuit elements (e.g. the P-channel transistor, N-channel transistors, first to fifth diodes and resistor) in the high-side gate drivers shown in figs. 2 and 3 may be suitably chosen according to design requirements.

In addition, preferably, in other examples, another ESD protection circuit may also be arranged between the voltage pin (VCP pin) and the gate pin (Gate pin) (i.e. between the input end of the first current mirror and the source of the first N-channel transistor). The ESD protection circuit may be formed of one or more unidirectionally conducting diodes. When the ESD protection circuit is formed of one unidirectionally conducting diode, a cathode of the diode is arranged to be connected to the input end of the first current mirror (i.e. the voltage pin VCP), and an anode of the diode is arranged to be connected to the source of the first N-channel transistor (i.e. the gate pin Gate). When the ESD protection circuit is formed of multiple unidirectionally conducting diodes, the multiple unidirectionally conducting diodes are arranged to be connected in series in the same direction, with a cathode of a first unidirectionally conducting diode being arranged to be connected to the input end of the first current mirror (i.e. the voltage pin VCP), and an anode of a final diode being arranged to be connected to the source of the first N-channel transistor (i.e. the gate pin Gate).

In addition, in another example not covered by the invention, the first N-channel transistor (Mn1) may be replaced by a resistance, with a parameter of the resistance being set such that current can be limited effectively when a negative voltage occurs at the gate relative to the source, and a chip parameter requirement of the high-side gate driver is met when the high-side gate driver is operating normally.

Using the high-side gate driver shown in fig. 3, the high-side gate driver is likewise enabled to meet a negative voltage requirement of the gate pin of the power transistor, with no need to additionally provide a current-limiting resistance between a gate output end of the high-side gate driver and a gate end of the transistor to be driven. In addition, by providing the voltage-limiting circuit between the source pin and ground, ESD protection can be carried out by means of the voltage-limiting circuit when ESD occurs.

## Claims

1. High-side gate driver, comprising: first and second current mirrors (Ip1, In1), a first N-channel transistor (Mn1), first and second switch circuits, first and second first-type diodes (d1, d2), and a first second-type diode (d3), and wherein
the first switch circuit is arranged between an output end of the first current mirror (Ip1) and a source of the first N-channel transistor (Mn1) such that when the first switch circuit is conducting, the first current mirror (Ip1) charges a gate pin connected to the source of the first N-channel transistor (Mn1), the second switch circuit is arranged between a drain of the first N-channel transistor (Mn1) and an input end of the second current mirror (In1) such that when the second switch circuit is conducting, the second current mirror (In1) discharges the gate pin,
an anode and a cathode of the first first-type diode (d1) are arranged to be connected to the source of the first N-channel transistor (Mn1) and a cathode of the second first-type diode (d2) respectively, an anode of the second first-type diode (d2) is arranged to be connected to an output end of the second current mirror (In1),
an anode and a cathode of the first second-type diode (d3) are arranged to be connected to ground and the cathode of the second first-type diode (d2) respectively,
an input end of the first current mirror (Ip1), the source of the first N-channel transistor (Mn1) and the output end of the second current mirror (In1) are connected to a voltage pin, the gate pin and a source pin of the high-side gate driver respectively, and the first N-channel transistor (Mn1), the second switch circuit and the second current mirror (In1) have a structure electrically isolated from a substrate, **characterized in that** the driver further comprises:
a voltage-limiting circuit arranged between the output end of the second current mirror (In1) and ground.

2. High-side gate driver according to Claim 1, **characterized in that** the structure electrically isolated from a substrate comprises an N-ring structure.

3. High-side gate driver according to Claim 1 or 2, **characterized in that** the driver further comprises:
a third first-type diode (d4), with an anode and a cathode of the third first-type diode (d4) being arranged to be connected to the cathode of the second first-type diode (d2) and the cathode of the first first-type diode (d1) respectively.

4. High-side gate driver according to any one of Claims 1 to 3, **characterized in that** the first switch circuit is realized by a P-channel transistor (Mp1), wherein a source and a drain of the P-channel transistor (Mp1) are arranged to be connected to the output end of the first current mirror (Ip1) and the source of the first N-channel transistor (Mn1) respectively.

5. High-side gate driver according to any one of Claims 1 to 4, **characterized in that** the second switch circuit is realized by a second N-channel transistor (Mn2) having a structure electrically isolated from a substrate, wherein a drain and a source of the second N-channel transistor (Mn2) are arranged to be connected to the drain of the first N-channel transistor (Mn1) and the input end of the second current mirror (In1) respectively.

6. High-side gate driver according to Claim 1, **characterized in that** the voltage-limiting circuit is realized by a second second-type diode and a clamping circuit.

7. High-side gate driver according to any one of Claims 1 to 6, **characterized in that** the first-type diode is a bidirectionally conducting diode, and the second-type diode is a unidirectionally conducting diode.

8. High-side gate driver according to Claim 7, **characterized in that** the first-type diode is a snapback ESD diode, and the second-type diode is an ESD diode.

9. Integrated circuit, **characterized by** comprising the high-side gate driver according to any one of Claims 1 to 8.

## Patentansprüche

1. Hochseitiger Gatetreiber, umfassend einen ersten und zweiten Stromspiegel (Ip1, In1), einen ersten N-Kanal-Transistor (Mn1), einen ersten und zweiten Schaltkreis, eine erste und zweite Diode (d1, d2) von einem ersten Typ und eine erste Diode (d3) von einem zweiten Typ, und wobei
der erste Schaltkreis angeordnet ist zwischen einem Ausgangsende des ersten Stromspiegels (Ip1) und einer Source des ersten N-Kanal-Transistors (Mn1), so dass, wenn der erste Schaltkreis leitend ist, und der erste Stromspiegel (Ip1) einen mit der Source des ersten N-Kanal-Transistors (Mn1) verbundenen Gatepin lädt, der zweite Schaltkreis zwischen einem Drain des ersten N-Kanal-Transistors (Mn1) und einem Eingangsende des zweiten Stromspiegels (In1) derart angeordnet ist, dass, wenn der zweite Schaltkreis leitend ist, der zweite Stromspiegel (In1) den Gatepin entlädt,
eine Anode und eine Kathode der ersten Diode (d1) von einem ersten Typ angeordnet sind, um mit der Source des ersten N-Kanal-Transistors (Mn1) beziehungsweise einer Kathode der zweiten Diode (d2) vom ersten Typ verbunden zu werden, eine Anode der zweiten Diode (d2) vom ersten Typ angeordnet ist, um mit einem Ausgangsende des zweiten Stromspiegels (In1) verbunden zu werden,
eine Anode und eine Kathode der ersten Diode (d3) vom zweiten Typ angeordnet sind, um mit Masse beziehungsweise der Kathode der zweiten Diode (d2) vom ersten Typ verbunden zu werden,
ein Eingangsende des ersten Stromspiegels (Ip1), die Source des ersten N-Kanal-Transistors (Mn1) und das Ausgangsende des zweiten Stromspiegels (In1) mit einem Spannungspin, dem Gatepin beziehungsweise einem Sourcepin des hochseitigen Gatetreibers verbunden sind und der erste N-Kanal-Transistor (Mn1), der zweite Schaltkreis und der zweite Stromspiegel (In1) eine elektrisch von einem Substrat getrennte Struktur aufweisen, **dadurch gekennzeichnet, dass** der Treiber weiter umfasst:
eine Spannungsbegrenzungsschaltung, die zwischen dem Ausgangsende des zweiten Stromspiegels (In1) und Masse angeordnet ist.

2. Hochseitiger Gatetreiber nach Anspruch 1, **dadurch gekennzeichnet, dass** die elektrisch von einem Substrat getrennte Struktur eine N-Ring-Struktur umfasst.

3. Hochseitiger Gatetreiber nach Anspruch 1 oder 2, **dadurch gekennzeichnet, dass** der Treiber weiter umfasst:
eine dritte Diode (d4) von einem ersten Typ, wobei eine Anode und eine Kathode der dritten Diode (d4) vom ersten Typ angeordnet ist, um mit der Kathode der zweiten Diode (d2) vom ersten Typ beziehungsweise der Kathode der ersten Diode (d1) vom ersten Typ verbunden zu werden.

4. Hochseitiger Gatetreiber nach einem der Ansprüche 1 bis 3, **dadurch gekennzeichnet, dass** der erste Schaltkreis durch einen P-Kanal-Transistor (Mp1) realisiert ist, wobei eine Source und ein Drain des P-Kanal-Transistors (Mp1) angeordnet sind, um mit dem Ausgangsende des ersten Stromspiegels (Ip1) beziehungsweise der Source des ersten N-Kanal-Transistors (Mn1) verbunden zu werden.

5. Hochseitiger Gatetreiber nach einem der Ansprüche 1 bis 4, **dadurch gekennzeichnet, dass** der zweite Schaltkreis durch einen zweiten N-Kanal-Transistor (Mn2) mit einer elektrisch von einem Substrat getrennten Struktur realisiert ist, wobei ein Drain und eine Source des zweiten N-Kanal-Transistors (Mn2) angeordnet sind, um mit dem Drain des ersten N-Kanal-Transistors (Mn1) beziehungsweise dem Eingangsende des zweiten Stromspiegels (In1) verbunden zu werden.

6. Hochseitiger Gatetreiber nach Anspruch 1, **dadurch gekennzeichnet, dass** die Spannungsbegrenzungsschaltung durch eine zweite Diode vom zweiten Typ und eine Klemmschaltung realisiert ist.

7. Hochseitiger Gatetreiber nach einem der Ansprüche 1 bis 6, **dadurch gekennzeichnet, dass** die Diode vom ersten Typ eine bidirektional leitende Diode ist und die Diode vom zweiten Typ eine unidirektional leitende Diode ist.

8. Hochseitiger Gatetreiber nach Anspruch 7, **dadurch gekennzeichnet, dass** die Diode vom ersten Typ eine Snapback-ESD-Diode ist und die Diode vom zweiten Typ eine ESD-Diode ist.

9. Integrierte Schaltung, **gekennzeichnet durch** das Umfassen des hochseitigen Gatetreibers nach einem der Ansprüche 1 bis 8.

## Revendications

1. Unité d'attaque de grille côté haut, comprenant : des premier et deuxième miroirs de courant (Ip1, In1), un premier transistor à canal N (Mn1), des premier et deuxième circuits commutateurs, des première et deuxième diodes de premier type (d1, d2), et une première diode de deuxième type (d3), et
le premier circuit commutateur étant agencé entre une extrémité de sortie du premier miroir de courant (Ip1) et une source du premier transistor à canal N (Mn1) de telle sorte que, lorsque le premier circuit commutateur est conducteur, le premier miroir de courant (Ip1) charge une broche de grille connectée à la source du premier transistor à canal N (Mn1), le deuxième circuit commutateur étant agencé entre un drain du premier transistor à canal N (Mn1) et une extrémité d'entrée du deuxième miroir de courant (In1) de telle sorte que, lorsque le deuxième circuit commutateur est conducteur, le deuxième miroir de courant (In1) décharge la broche de grille,
une anode et une cathode de la première diode de premier type (d1) étant agencées pour être connectées respectivement à la source du premier transistor à canal N (Mn1) et à une cathode de la deuxième diode de premier type (d2), une anode de la deuxième diode de premier type (d2) étant agencée pour être connectée à une extrémité de sortie du deuxième miroir de courant (In1),
une anode et une cathode de la première diode de deuxième type (d3) étant agencées pour être connectées respectivement à la terre et à la cathode de la deuxième diode de premier type (d2),
une extrémité de sortie du premier miroir de courant (Ip1), la source du premier transistor à canal N (Mn1) et l'extrémité de sortie du deuxième miroir de courant (In1) étant connectées respectivement à une broche de tension, à la broche de grille et à une broche de source de l'unité d'attaque de grille côté haut, et le premier transistor à canal N (Mn1), le deuxième circuit commutateur et le deuxième miroir de courant (In1) ayant une structure isolée électriquement d'un substrat, l'unité d'attaque étant **caractérisée en ce qu'**elle comprend :
un circuit de limitation de tension agencé entre l'extrémité de sortie du deuxième miroir de courant (In1) et la terre.

2. Unité d'attaque de grille côté haut selon la revendication 1, **caractérisée** en que la structure isolée électriquement d'un substrat comprend une structure en anneau de type N.

3. Unité d'attaque de grille côté haut selon la revendication 1 ou 2, l'unité d'attaque étant **caractérisée en ce qu'**elle comprend en outre :
une troisième diode de premier type (d4), avec une anode et une cathode de la troisième diode de premier type (d4) agencées pour être connectées respectivement à la cathode de la deuxième diode de premier type (d2) et à la cathode de la première diode de premier type (d1) .

4. Unité d'attaque de grille côté haut selon l'une quelconque des revendications 1 à 3, **caractérisée en ce que** le premier circuit commutateur est réalisé par un transistor à canal P (Mp1), une source et un drain du transistor à canal P (Mp1) étant agencés pour être connectés respectivement à l'extrémité de sortie du premier miroir de courant (Ip1) et à la source du premier transistor à canal N (Mn1).

5. Unité d'attaque de grille côté haut selon l'une quelconque des revendications 1 à 4, **caractérisée en ce que** le deuxième circuit commutateur est réalisé par un deuxième transistor à canal N (Mn2) ayant une structure isolée électriquement d'un substrat, un drain et une source du deuxième transistor à canal N (Mn2) étant agencés pour être connectés respectivement au drain du premier transistor à canal N (Mn1) et à l'extrémité d'entrée du deuxième miroir de courant (In1).

6. Unité d'attaque de grille côté haut selon la revendication 1, **caractérisée en ce que** le circuit de limitation de tension est réalisé par une deuxième diode de deuxième type et un circuit de calage.

7. Unité d'attaque de grille côté haut selon l'une quelconque des revendications 1 à 6, **caractérisée en ce que** la diode de premier type est une diode conductrice de manière bidirectionnelle, et la diode de deuxième type est une diode conductrice de manière unidirectionnelle.

8. Unité d'attaque de grille côté haut selon la revendication 7, **caractérisée en ce que** la diode de premier type est une diode ESD à repliement, et la diode de deuxième type est une diode ESD.

9. Circuit intégré, **caractérisé en ce qu'**il comprend l'unité d'attaque de grille côté haut selon l'une quelconque des revendications 1 à 8.
